# EUROPÄISCHE PATENTSCHRIFT

(11) **EP 1 021 939 B1**
(45) Veröffentlichungstag und Bekanntmachung des Hinweises auf die Patenterteilung: **07.04.2004**
(21) Anmeldenummer: 97951104.5
(22) Anmeldetag: 01.12.1997
(51) Int. Cl.: H05K 7/02, H05K 7/14

(54) **ELEKTRISCHES GERÄT MIT MODULARER AUFBAUTECHNIK**
MODULAR ELECTRIC APPARATUS
APPAREIL ELECTRIQUE DE CONCEPTION MODULAIRE

(30) Priorität: 13.12.1996 DE 19651961
(43) Veröffentlichungstag der Anmeldung: 26.07.2000
(73) Patentinhaber: SIEMENS AKTIENGESELLSCHAFT, 80333 München (DE)
(72) Erfinder: ROHNE, Klaus, D-09350 Lichtenstein (DE); BEYER, Hans-Jürgen, D-08134 Wildenfels (DE); MEIER, Frank-Günter, D-09212 Limbach-Oberfrohna (DE)
(86) Internationale Anmeldenummer: PCT/DE1997/002805
(87) Internationale Veröffentlichungsnummer: WO 1998/026640

(56) Entgegenhaltungen:
- DE-C- 4 438 806

## Beschreibung

Die vorliegende Erfindung betrifft ein elektrisches Gerät mit modularer Aufbautechnik zur Steuerung und/oder Überwachung eines technischen Prozesses mit mindestens einem Peripheriemodul mit mindestens einem Eingangs- bzw. Ausgangskanal zum elektrisch leitenden Anschluß von Sensoren bzw. Aktoren des technischen Prozesses und mindestens einem Kopfmodul zur Ansteuerung der Peripheriemodule über einen Bus, der durch die Module hindurchgeschleift ist.

Derartige elektrische Geräte sind heutzutage allgemein geläufig. So ist beispielsweise ein Automatisierungsgerät mit einem Kopfmodul handelsüblich, an das als Modulscheiben ausgebildete Peripheriemodule angereiht werden. Das Kopfmodul steuert die Module über einen Bus, dessen Signale von Modul zu Modul weitergeleitet werden. Nachteilig bei diesem Automatisierungsgerät ist jedoch, daß der Bus unterbrochen wird, sobald ein Modul aus dem Verband entfernt wird. Ein Ziehen und Stecken einzelner Module im Betrieb ist somit nicht möglich. Weiterhin sind beim bekannten Automatisierungsgerät die benötigten Potentialanschlüsse ebenfalls im Modul integriert und werden über Kontakte von Modul zu Modul weitergereicht. Aus diesem Grunde besteht ein weiterer Nachteil dieses Automatisierungsgerätes darin, daß ein Ziehen und Stecken einzelner Module auch zur Unterbrechung der Potentialweitergabe führt. Ferner ist in nachteiliger Weise zur Bildung von Potentialinseln oder bei der Einspeisung weiterer Potentiale eine zusätzliche Modulscheibe - d. h. ein zusätzlicher Steckplatz - erforderlich.

Ein weiteres handelsübliches Automatisierungsgerät enthält die benötigten Potentialanschlüsse in einer bestimmten, fest vorgegebenen Klemmstellenanzahl als durchgehende feste Verbindungen, z. B. in Form einer Leiterplatte oder in Form von Drahtbrücken, so daß sich eine sogenannte stehende Verdrahtung ergibt. Das Basismodul weist darüber hinaus einen durchgängigen, fest verdrahteten Bus auf. Zum Einsatz mit dem Basismodul sind Peripheriemodule vorgesehen, die auf dieses Basismodul aufsteckbar bzw. aufrastbar sind. Für eine bestimmte Anzahl einzelner Peripheriemodule ist dabei je ein Steckplatz vorgesehen. Die Anzahl der Peripheriemodule und damit die Anzahl der an die Peripheriemodule anschließbaren Eingangs- bzw. Ausgangskanäle wird sowohl durch die mechanische Ausgestaltung des Basismoduls, d. h. die Anzahl der zur Verfügung stehenden Steckplätze als auch durch die Funktionalität des Basismoduls, d. h. die vom Basismodul handhabbaren Eingangs- bzw. Ausgangskanäle, festgelegt und somit begrenzt. Werden mehr Module bzw. Kanäle benötigt als mit einem Basismodul handhabbar sind, ist ein weiteres Basismodul notwendig, auch wenn dieses nicht voll bestückt wird. Werden weniger Module bzw. Kanäle benötigt als mit dem Block handhabbar sind, muß trotzdem der komplette Block eingesetzt werden. Dieses im Stand der Technik bekannte Automatisierungsgerät ermöglicht bereits ein Ziehen und Stecken einzelner Peripheriemodule im Betrieb. Allerdings bildet jedes Basismodul eine mehr oder weniger abgeschlossene Potentialinsel.

Aufgabe der vorliegenden Erfindung ist es, ein elektrisches Gerät in modularer Aufbautechnik zu schaffen, bei dem insbesondere die Verschaltung zwischen den Modulen und innerhalb der Module äußerst einfach gestaltet ist.

Die Aufgabe wird durch ein elektrisches Gerät mit den im Anspruch 1 angegebenen Merkmalen gelöst. Der Vorteil des erfindungsgemäßen elektrischen Gerätes besteht in der erhöhten Flexibilität und Vielseitigkeit bei gleichzeitig verbesserter Konfigurierbarkeit.

Weitere Vorteile und erfinderische Einzelheiten ergeben sich aus der nachfolgenden Beschreibung eines Ausführungsbeispiels, anhand der Zeichnungen und in Verbindung mit den Unteransprüchen. Im einzelnen zeigen
- FIG 1: aneinandergereihte Sockelteile mit teilweise aufgesteckten Elektronikmodulen,
- FIG 2: ein einzelnes Modul in Explosionsdarstellung,
- FIG 3: eine Steuerungs- und/oder Überwachungseinrichtung mit nur einer Schnittstellenebene,
- FIG 4: eine Steuerungs- und/oder Überwachungseinrichtung mit nur einer Schnittstellenebene zwischen erster und zweiter Bauteileinheit, wobei auf der ersten Bauteileinheit eine Digitalausgabeschaltung und eine Digitaleingabeschaltung angeordnet ist,
- FIG 5: einen Potentialkontakt,
- FIG 6: kontaktierte Potentialkontakte,
- FIG 7: einen Potentialeinspeisestecker,
- FIG 8: eine Potentialeinspeisung beim kaskadierbaren Kontaktsystem,
- FIG 9 und FIG 10: eine elektrische Anschlußvorrichtung aus verschiedenen Blickrichtungen,
- FIG 11: eine elektrische Anschlußvorrichtung mit betätigten Hebelelementen und
- FIG 12: eine elektrische Anschlußvorrichtung in Teil-Explosionsdarstellung.

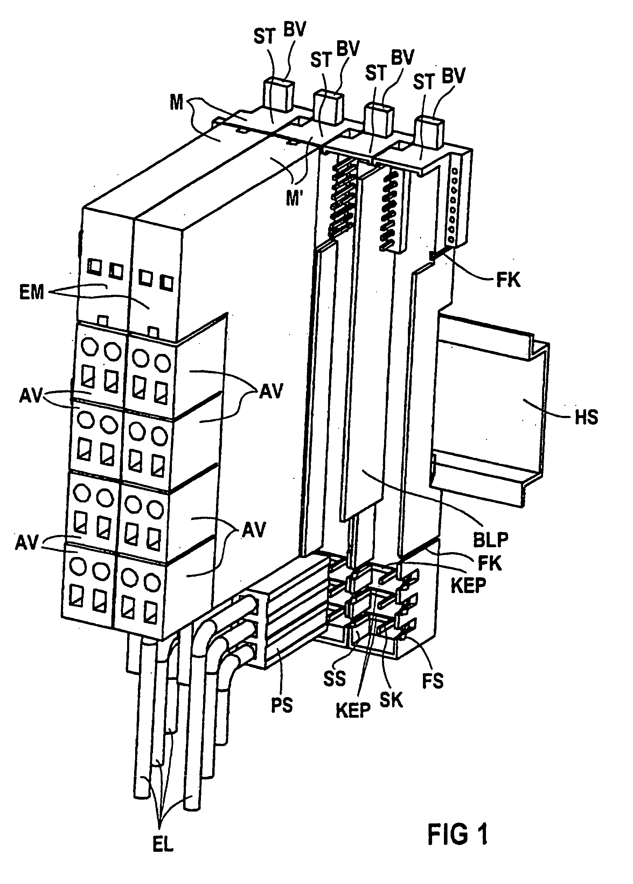

FIG 1 zeigt eine Vielzahl von aneinandergereihten Sockelteilen ST, wobei auf einige dieser Sockelteile ST jeweils ein Elektronikmodul EM mit einer Anschlußvorrichtung AV sowie ein Potentialeinspeisestecker PS aufgebracht ist. Das Sockelteil ST bildet die konstruktive Basis des aus Sockelteil ST, Elektronikmodul EM, Anschlußvorrichtung AV und Potentialeinspeisestecker PS gebildeten Moduls M, M', wobei ein einzelnes Modul M, M' im folgenden auch als Modulscheibe M, M' bezeichnet wird.

Die einzelnen Sockelteile ST sind auf einer Hutschiene HS aufgerastet. Zum paßgenauen Aneinanderreihen der einzelnen Sockelteile ST weist jedes Sockelteil auf der einen Seite eine Führungskontur FK auf, in die beim paßgenauen Aneinanderreihen eine zur Führungskontur FK formschlüssig ausgebildete Führungsaufnahme FK', die auf der gegenüberliegenden Seite des Sockelteils ST angeordnet und in FIG 1 nicht dargestellt ist, eingreift. Die Führungskontur FK kann z. B. als Schwalbenschwanz FK, die Führungsaufnahme FK' als Schwalbenschwanzaufnahme FK' ausgebildet sein.

Die Sockelteile ST werden entweder zunächst über die Führungskontur FK, FK' paßgenau aneinandergereiht und dann auf die Hutschiene HS aufgerastet oder aber es wird zunächst ein Sockelteil ST auf die Hutschiene HS aufgerastet und sodann das anzureihende weitere Sockelteil ST zunächst paßgenau mittels der Führungskontur FK, FK' an das bereits aufgerastete Sockelteil ST angefügt und sodann in der durch die Führungsköntur FK ermöglichten Bewegungsrichtung an die Hutschiene HS herangeführt und dort schließlich aufgerastet.

Zum Lösen der einzelnen Sockelteile ST von der Hutschiene HS weist jedes Sockelteil ST eine Betätigungsvorrichtung BV auf, mit der eine im Stand der Technik allgemein bekannte Aufrastvorrichtung zum Aufrasten auf eine Profilschiene lösbar ist.

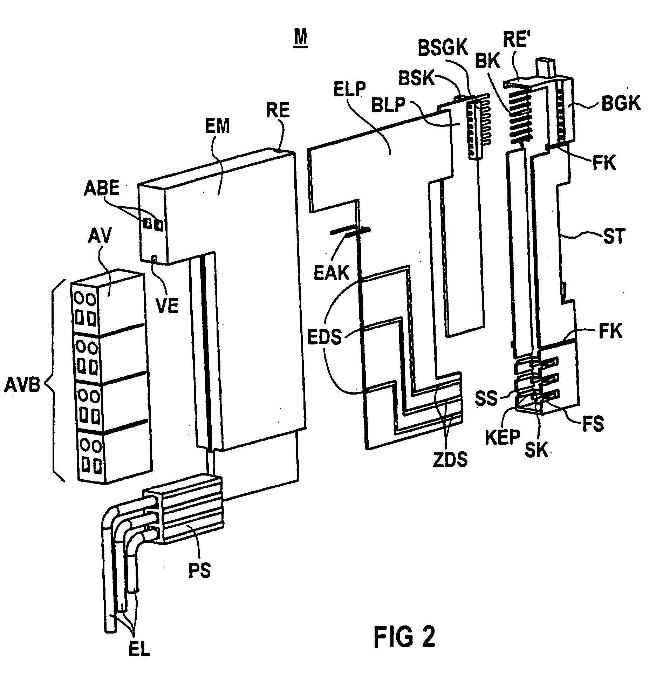

Zur Weiterleitung des durch aneinandergereihte Module M, M' hindurchgeschleiften Busses weist jedes Sockelteil ST ein Buskontaktelement BK, das im Ausführungsbeispiel als einreihige Stiftleiste BK ausgebildet ist, und ein Busgegenkontaktelement BGK, das im Ausführungsbeispiel als einreihige Buchsenleiste BGK ausgebildet ist, auf. Die einzelnen Kontaktelemente von Buskontaktelement BK und Busgegenkontaktelement BGK sind innerhalb des Sockelteiles ST in nicht dargestellter Weise jeweils elektrisch leitend miteinander verbunden. Die diesbezügliche Anordnung ist besonders gut aus FIG 2 ersichtlich, die ein einzelnes Modul M in einer Explosionsdarstellung zeigt.

Zur Weiterführung des Busses von einem Sockelteil ST eines ersten Moduls M zu einem weiteren Sockelteil ST eines benachbarten Moduls M' dient die Busleiterplatte BLP, mit der ein Bussteckverbinder-Kontaktelement BSK und ein Bussteckverbinder-Gegenkontaktelement BSGK elektrisch leitend verbunden ist.

Das Bussteckverbinder-Kontaktelement BSK ist im Ausführungsbeispiel als einreihige Stiftkontaktleiste BSK ausgebildet, so daß mit diesem das Busgegenkontaktelement BGK kontaktierbar ist. Entsprechend ist mit Bussteckverbinder-Gegenkontaktelement BSGK, das im Ausführungsbeispiel als einreihige Buchsenleiste BSGK ausgebildet ist, das Buskontaktelement BK kontaktierbar. Da das Sockelteil ST im Ausführungsbeispiel selbst keine aktiven Bauelemente aufweist, sind die aktiven Bauelemente, z. B. zur Signalauffrischung der über den Bus übertragenen Daten und/oder Signale auf der Busleiterplatte BLP angeordnet. Auf der Busleiterplatte BLP befindet sich damit einerseits die Elektronik des aktiven Rückwandbusses mit geeigneter Ankopplung an die Elektronik des Elektronikmoduls EM, die sowohl auf elektrischem und/oder optischem Wege erfolgen kann, und andererseits, wie beschrieben, eine Bussteckverbinderkombination BSK, BSGK, welche die Busleiterplatte BLP mit entsprechender Komponente des Sockelteils ST elektrisch leitend verbindet.

Die Busleiterplatte BLP trägt darüber hinaus auch die notwendigen elektronischen Bauelemente, die z. B. für die Erkennung des jeweiligen Steckplatzes erforderlich sind. Mittels der eindeutigen Steckplatzerkennung werden die für das jeweilige Modul M, M' bestimmten Daten aus dem über den Bus laufenden Datenfluß identifiziert, registriert und behandelt. Da die Busleiterplatte BLP lösbar mit dem Sockelteil ST verbindbar ist, kann sie auch - im Ausführungsbeispiel nach dem Entfernen des Elektronikmoduls EM - vom Sockelteil ST gelöst werden. Dies ermöglicht, falls erforderlich, das Herausnehmen bzw. das Auswechseln des vorherigen Sockelteils ST aus dem Sockelverband, ohne alle Sockelteile ST abbauen zu müssen.

Das Elektronikmodul EM besteht aus einem oder mehreren Gehäuseteilen, in welchen sich die entsprechende Elektronik befindet. Diese Elektronik ist im Ausführungsbeispiel konventionell auf einer Elektronikmodulleiterplatte ELP installiert, die in das Elektronikmodul EM eingeschoben oder eingelegt und damit von Gehäuseteilen weitestgehend umhüllt ist. Im Frontbereich des Elektronikmoduls EM sind Anzeige- bzw. Bedienelemente ABE und die Elektronikmodulkennung angeordnet. Das Elektronikmodul EM ist mittels der Verrastungselemente RE, RE' lösbar mit dem Sockelteil ST verrastbar.

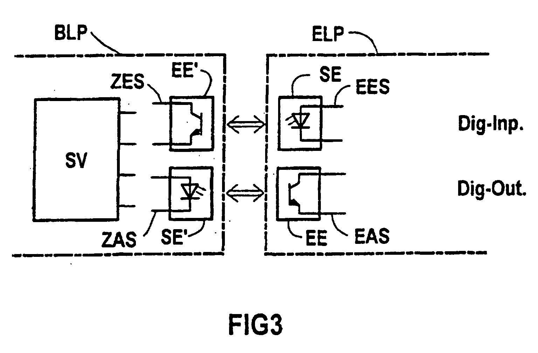

FIG 3 zeigt eine Steuerungs- und/oder Überwachungseinrichtung mit einer durch ein Senderelement und ein korrespondierendes Empfängerelement gebildeten Schnittstellenebene. Ein erster Eingangsstromkreis EES sowie ein erster Ausgangsstromkreis EAS sind gemäß dem Ausführungsbeispiel auf einer Elektronikmodulleiterplatte ELP angeordnet. Im ersten Eingangsstromkreis EES befindet sich ein Senderelement SE; im ersten Ausgangsstromkreis EAS befindet sich ein Empfängerelement EE.

Auf der von der Elektronikmodulleiterplatte ELP getrennten Busleiterplatte BLP befinden sich dem Senderelement SE gegenüberliegend angeordnet ein Empfängerelement EE' und ein dem Empfängerelement EE gegenüberliegend angeordnetes Senderelement SE'. Das Empfängerelement EE' ist im zweiten Eingangsstromkreis ZES, das Senderelement SE' im zweiten Ausgangsstromkreis ZAS angeordnet.

Der zweite Eingangsstromkreis ZES sowie der zweite Ausgangsstromkreis ZAS ist in nicht dargestellter Weise mit einer auf der Busleiterplatte BLP angeordneten Signalverarbeitungseinrichtung SV verbunden, wobei die Signalverarbeitungseinrichtung SV z.B. ein Mikroprozessor SV mit einem diesem zugeordneten Speicherbereich ist, wobei der Mikroprozessor SV z.B. über Kommunikationsmittel Daten von einer übergeordneten Einheit empfängt und Daten an diese übergeordnete Einheit übermittelt. Aufgrund der von der übergeordneten Einheit empfangenen Daten, schaltet die Signalverarbeitungseinrichtung SV z.B. eine bestimmte Digitalausgabe auf logisch 1, beziehungsweise übermittelt den logischen Zustand einer Digitaleingabe an die übergeordnete Einheit.

Die Signalübertragung zwischen Senderelement SE, SE' und Empfängerelement EE', EE erfolgt über eine elektromagnetische Welle oder ein elektromagnetisches Feld. Im Ausführungsbeispiel ist das Senderelement SE, SE' als Diode ausgebildet, die eine elektromagnetische Welle im Infrarotbereich ausstrahlt. Entsprechend ist das Empfängerelement EE, EE' als Detektor zur Detektion einer elektromagnetischen Welle im Infrarotbereich ausgebildet. Die einander zugeordneten Sender- und Empfängerelemente SE, EE' bzw. EE, SE' sind jeweils auf unterschiedlichen, beabstandeten Leiterplatten ELP, BLP angeordnet.

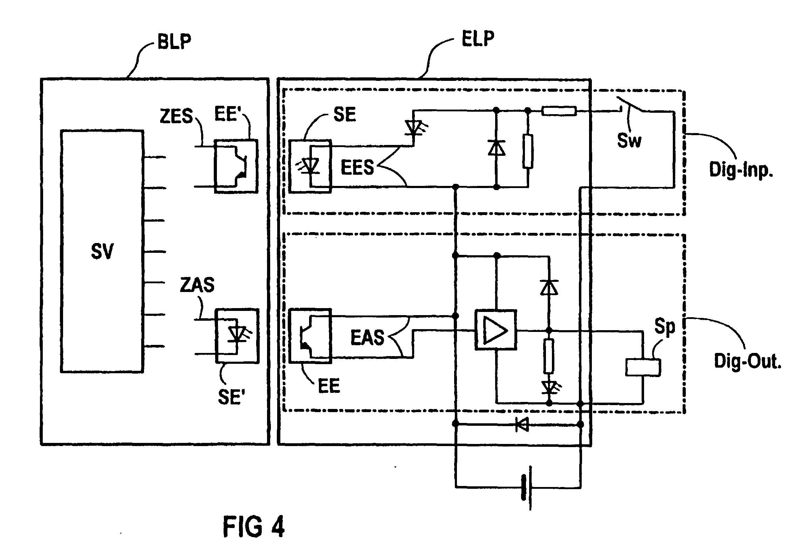

In FIG 4 ist auf der Elektronikmodulleiterplatte ELP eine Digitaleingabe mit dem ersten Eingangsstromkreis EES und dem darin angeordneten Senderelement SE sowie eine Digitalausgabe mit dem ersten Ausgangsstromkreis EAS und dem darin angeordneten Empfängerelement EE dargestellt. Selbstverständlich kann auf der Elektronikmodulleiterplatte ELP anstelle der Digitaleingabe auch eine Analogeingabe und/oder anstelle der Digitalausgabe auch eine Analogausgabe angeordnet sein. Die an die Digitalausgabe angeschlossene Prozeßperipherie, die z.B. ein Aktor oder ein Stellglied sein kann, ist exemplarisch als Schützspule Sp dargestellt. Die an die Digitaleingabe angeschlossene Prozeßperipherie, die ein Sensor im weitesten Sinne sein kann, ist exemplarisch als Schalter Sw dargestellt. Auf der Busleiterplatte BLP ist für die Digitaleingabe dem Senderelement SE gegenüberliegend das Empfängerelement EE' angeordnet, das sich im zweiten Eingangsstromkreis ZES befindet. Für die Digitalausgabe ist auf der Busleiterplatte BLP dem Empfängerelement EE gegenüberliegend das Senderelement SE' angeordnet, das sich im zweiten Ausgangsstromkreis ZAS befindet. Der zweite Eingangsstromkreis ZES und der zweite Ausgangsstromkreis ZAS sind in in FIG 4 nicht dargestellter Weise mit der Signalverarbeitungseinrichtung SV verbunden.

Die Signalverarbeitungseinrichtung SV ist in nicht dargestellter, jedoch an sich bekannter Weise mit einer übergeordneten Einheit, z.B. der Zentraleinheit einer speicherprogrammierbaren Steuerung, über Kommunikationsmittel, beispielsweise über einen Feldbus, verbindbar. Die Signalverarbeitungseinrichtung SV gibt über diese Kommunikationsmittel die von einer auf einer Elektronikmodulleiterplatte ELP beispielsweise angeordneten Digitaleingabe empfangenen Eingangswerte an die übergeordnete Einheit weiter. Analog steuert die Signalverarbeitungseinrichtung SV auch die auf einer Elektronikmodulleiterplatte ELP beispielsweise angeordnete Digitalausgaben entsprechend der von der übergeordneten Einheit empfangenen Daten auf logisch 1 oder logisch 0.

Zur effektiven Steuerung und/oder Überwachung eines technischen Prozesses weist die Busleiterplatte BLP zumindest einen speziellen Bereich auf, in dem eine der Busleiterplate BLP zuordenbare Elektronikmodulleiterplatten ELP plazierbar ist. Der mindestens eine Bereich für Elektronikmodulleiterplatten ELP ist entweder durch Anordnung eines Empfängerelementes EE' an diesem Bereich für eine auf einer Elektronikmodulleiterplatte ELP angeordnete Digitaleingabe vorkonfektioniert oder aber durch Anordnung eines Senderelementes SE' für eine auf einer Elektronikmodulleiterplatte ELP angeordnete Digitalausgabe vorkonfektioniert.

Wenn in dem mindestens einen Bereich jedoch sowohl ein Senderelement SE' als auch ein Empfängerelement EE' vorgesehen ist, ist mit der Busleiterplatte ELP sowohl eine Elektronikleiterplatte ELP mit einer Digitalausgabe als auch eine Elektronikmodulleiterplatte ELP mit einer Digitaleingabe kombinierbar.

Der Signalverarbeitungseinrichtung SV wird für jede zugeordnete Elektronikmodulleiterplatte ELP übermittelt, welche Konfiguration, d.h. Digitaleingabe oder Digitalausgabe bzw. Digitalausgabe und Digitaleingabe, auf dieser Elektronikmodulleiterplatte ELP vorhanden ist. Die Übermittlung der Konfiguration erfolgt z.B. über eine nicht dargestellte mechanische Kodiervorrichtung, die auf der Busleiterplatte BLP angeordnet ist und beim Positionieren der Elektronikmodulleiterplatte ELP betätigt wird.

Für den Fall, daß auf der Elektronikmodulleiterplatte ELP weder eine Digitaleingabe noch eine Digitalausgabe, sondern z.B. eine sogenannte intelligente Peripherieeinheit mit z.B. einem eigenen Mikroprozessor oder einem ASIC angeordnet ist, kann beim Positionieren der Elektronikmodulleiterplatte ELP oder beim Einschalten der Versorgungsspannung für die Busleiterplatte BLP mit Hilfe eines definierten Protokolls, dessen Signale zwischen Senderelement SE bzw. SE' und Empfängerelement EE bzw. EE' übertragen werden, ein sogenannter Identlauf initiiert werden, in dessen Verlauf die auf der Elektronikmodulleiterplatte ELP angeordnete intelligente Peripheriebaugruppe, der auf der Busleiterplatte BLP angeordneten Signalverarbeitungseinrichtung SV ihre Konfiguration übermittelt.

Gemäß dem Ausführungsbeispiel ist die aus Elektronikmodulleiterplatte ELP und Busleiterplatte BLP gebildete Steuerungsund/oder Überwachungseinrichtung als Modul M, M' eines modularen Automatisierungsgerätes, z.B. als Modul M, M' eines dezentralen Peripheriegerätes, ausgebildet, wobei in diesem Automatisierungsgerät eine Vielzahl von als einzelne Module M, M' ausgebildete Steuerungs- und/oder Überwachungseinrichtungen mit Elektronikmodulleiterplatte ELP und Busleiterplatte BLP plaziert sind.

Die jeweiligen Signalverarbeitungseinrichtungen SV der Busleiterplatte BLP sind dabei z.B. über einen zentralen Bus des Automatisierungsgerätes verbunden. Zustände des technischen Prozesses, die z.B. über die im technischen Prozeß angeordneten Sensoren mittels auf der Elektronikmodulleiterplatte ELP angeordneter Eingangsstromkreise ermittelt wurden, werden über die Signalverarbeitungseinrichtung SV an eine intelligente Einheit eines zentralen Moduls M, M' des Automatisierungsgerätes übermittelt. Diese intelligente Einheit des zentralen Moduls M, M' des Automatisierungsgerätes, die z.B. in einem speziellen Modul M, M' des Automatisierungsgerätes angeordnet ist, kommuniziert z.B. über Kommunikationsmittel mit übergeordneten Einheiten, z.B. einer Zentraleinheit einer speicherprogrammierbaren Steuerung.

Eine komplette Modulscheibe M, M' - bestehend aus Sockelteil ST, Elektronikmodul EM sowie erforderlichenfalls Anschlußvorrichtung AV und Potentialeinspeisestecker PS - wird neben z. B. einem in FIG 1 nicht dargestellten Kopfmodul mittels der Führungskontur FK im Sockelteil ST paßgenau am Kopfmodul angeordnet und auf einer Hutschiene HS aufgerastet. Über das Sockelteil ST verrastet die komplette Modulscheibe M, M' mit der Hutschiene HS. Eine zweite Modulscheibe M, M' wird wieder mittels der Führungskontur FK paßgenau positioniert und verrastet ebenfalls auf der Hutschiene HS.

Die beiden Sockelteile ST sind über die Führungskontur FK und durch die Verrastung auf der Hutschiene HS mechanisch miteinander verbunden. Die jeweiligen Elektronikmodule EM sind im Ausführungsbeispiel nicht untereinander verrastet, sondern jeweils nur mit ihrem Sockelteil ST über die Verrastungselemente RE, RE' verrastet. Auf die bereits beschriebene Art und Weise wird auch die nächste komplette Modulscheibe M, M' aufgeschoben. Wieder verrastet das Sockelteil ST auf der Hutschiene HS, wobei es mittels der die Führungskontur FK in paßgenauer Anordnung zum vorhergehenden Sockelteil ST gehalten ist.

Damit wird ein von anderen Teilen unabhängiger Sockelverband, bestehend aus mindestens zwei Sockelteilen ST auf der Hutschiene HS gebildet. Durch die konstruktive Auslegung der Buskontakte BGK, BK im Sockelteil ST und der Busleiterplatte BLP mit den darauf angeordneten Bussteckverbinder-Kontaktelementen BSK, BSGK entsteht in diesem Sockelverband ein von den Elektronikmodulen EM unabhängiger durchgehender Bus. Der Bus verläuft vom Busgegenkontaktelement BGK eines ersten Sockelteils ST eines Moduls M zum Bussteckverbinder-Kontaktelement BSK der Busleiterplatte BLP eines nachfolgenden Sockelteils ST des dem ersten Modul M benachbart angeordneten Moduls M'. Über die Elektronik der Busleiterplatte BLP wird der Bus dann zum Bussteckverbinder-Gegenkontaktelement BSGK auf Buskontaktelemente BK des nachfolgenden Sockelteils ST und weiter zum Busgegenkontaktelement BGK geführt. Von hier aus verläuft der Bus weiter bis zum nächsten Sockelteil ST, und zwar über dessen Busleiterplatte BLP und der auf dieser angeordneten Bussteckverbinder-Kontaktelementkombination BSK, BSGK.

Die einzelnen Elektronikmodule EM sind durch Öffnen der Verrastungselemente RE, RE' von ihrem jeweiligen Sockelteil ST lösbar. Das zugehörige Sockelteil ST mit der Busleiterplatte BLP verbleibt auf der Hutschiene HS und im Verband mit den anderen Sockelteilen ST. Damit bleibt auch der im Sockelverband bestehende und durch die auf der Busleiterplatte BLP befindliche Elektronik noch aktive Bus erhalten, d. h. er wird nicht unterbrochen, so daß ein Ziehen und Stecken der Elektronikmodule EM im Betrieb jederzeit möglich ist.

Durch die Konstruktion der einzelnen Komponenten der Module M, M' ist mechanisch ein Austausch z. B. der Elektronikmodule EM (Ersetzen von z. B. Eingabemodulen durch Ausgabemodule) problemlos möglich. Es können auch mehrere Elektronikmodule EM gleichzeitig gezogen und entfernt werden, wobei auch in diesem Fall ein unterbrechungsfreier Betrieb des Busses in jedem Fall gewährleistet ist. Ebenso können nur die Sockelteile ST separat, d. h. ohne Elektronikmodule EM, in gleicher Weise wie ein komplettes Modul M, M' auf die Hutschiene HS aufgerastet werden. Der Sockelverband kann dadurch einfach erweitert oder ggf. vorab aufgebaut werden.

Die im Sockelteil ST befindlichen Potentialkontakte KEP sind im unteren Abschnitt des Sockelteils ST angeordnet und so ausgelegt, daß sie in einem gemäß dem oben geschilderten Vorgehen entstehenden Sockelverband einen entsprechenden Potentialkontakt KEP des Nachbarsockelteiles ST elektrisch leitend kontaktieren. Ähnlich wie der Bus, in diesem Falle aber gemäß dem Ausführungsbeispiel passiv, werden hier die Potentiale von einem ersten Sockelteil ST zu einem benachbarten weiteren Sockelteil ST weitergeschleift, wobei diese Kontaktierung unabhängig von eventuell vorhandenen Elektronikmodulen EM ist. Ein Ziehen der Elektronikmodule EM unterbricht somit nicht die Potentialweiterleitung im Sockelverband.

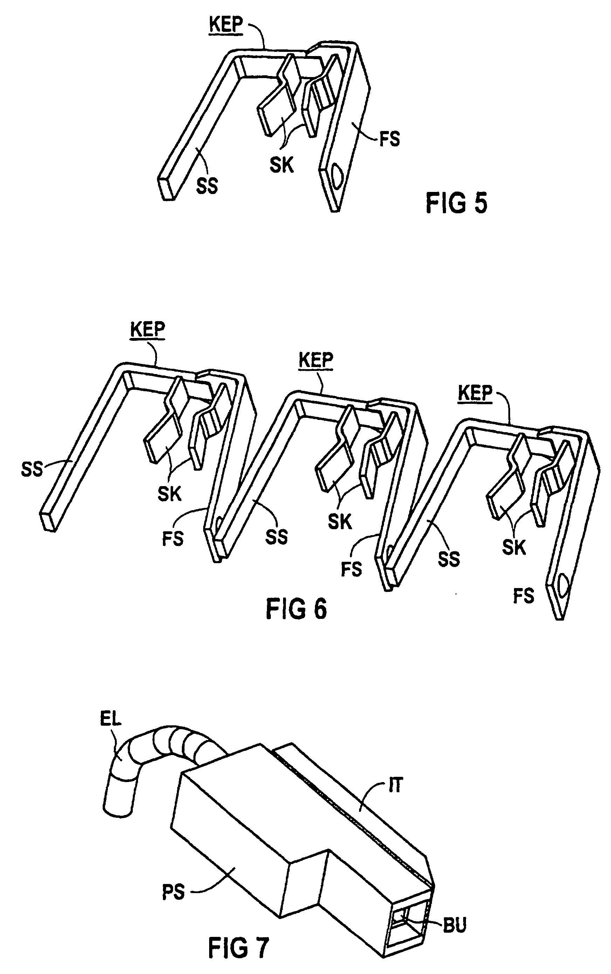

Gemäß FIG 1 sind in den Sockelteilen ST der Module M, M', die jeweils benachbart angeordnet sind, Potentialkontakte KEP plaziert. Wie besonders aus FIG 5 ersichtlich ist, ist der Potentialkontakt KEP im wesentlichen U-förmig ausgebildet, wobei einer der Schenkel des U-förmigen Potentialkontaktes KEP als starrer Schenkel SS und der andere Schenkel des U-förmigen Potentialkontaktes KEP als federnder Schenkel FS ausgebildet ist.

Zum Abgreifen des mit einem Potentialkontakt KEP weitergeleiteten Potentials weist der Potentialkontakt KEP weitere Steckkontakte SK auf, die im Ausführungsbeispiel gemäß FIG 5 auf der Basis des U-förmigen Potentialkontaktes KEP angeordnet sind und z. B. gemäß FIG 5 als direkter Steckverbinder SK ausgebildet sind oder auch als indirekte Steckverbinder ausgebildet sein können.

Die Kontaktierung der in den Sockelteilen ST der Module M, M' angeordneten Potentialkontakte KEP ist besonders gut anhand von FIG 6 ersichtlich. Die Potentialkontakte KEP bilden eine Potentialkontaktkette, bei der jeweils ein federnder Schenkel FS eines ersten Potentialkontaktes KEP unter mäßigem Druck am starren Schenkel SS eines benachbart plazierten zweiten Potentialkontaktes KEP anliegt.

Die Anordnung der Potentialkontakte KEP im Sockelteil ST der Module M, M' ist beim Ausführungsbeispiel gemäß FIG 1 derart gewählt, daß das Sockelteil ST eines ersten Moduls M Aussparungen aufweist, in die der Potentialkontakt KEP dieses Moduls M derart eingreift, daß der starre Schenkel SS dieses Potentialkontaktes KEP kontaktierbar ist, und daß der federnde Schenkel FS dieses Potentialkontaktes KEP den starren Schenkel SS des im Sockelteil ST des benachbarten Moduls M' angeordneten Potentialokontaktes KEP kontaktieren kann. Zur Potentialweiterleitung sind damit die einzelnen Potentialkontakte KEP räumlich derart angeordnet, daß immer ein federnder Schenkel FS eines ersten Potentialkontaktes KEP unter mäßigem Druck am starren Schenkel SS des Nachbarpotentialkontaktes KEP anliegt.

Eine derartige räumliche Anordnung wird unmittelbar bewirkt, wenn mindestens zwei Module M, M' des elektrischen Gerätes z.B. auf einer Hutschiene HS, wie in FIG 1 dargestellt, nebeneinander angeordnet sind. Damit ergibt sich eine geschlossene Potentialkontaktkette. Anliegende Potentiale werden so von Potentialkontakt KEP zu Potentialkontakt KEP weitergeleitet, d. h. jedem einzelnen Modul M, M' wird das eingespeiste Potential zugeführt und über das Modul M, M' an das Nachbarmodul M, M' weitergegeben.

Für jedes Modul M, M' des elektrischen Gerätes können mehrere - im Ausführungsbeispiel gemäß FIG 1 drei - gleichartige Potentialkontakte KEP für unterschiedliche Potentiale vorgesehen sein, die damit unabhängige Potentialkontaktketten oder Potentialketten zur Weiterleitung jeweils eines Potentials bilden. Im Ausführungsbeispiel sind die drei Potentialkontakte KEP, die jeweils in einem Sockelteil ST eines Moduls M, M' angeordnet sind, zueinander parallel ausgerichtet. Im Falle mehrerer Potentialkontakte KEP in einem Modul M, M' zur Weiterleitung unterschiedlicher Potentiale sind die Potentialkontakte KEP eines Moduls M, M' untereinander selbstverständlich isoliert.

Um verschiedene Potentialinseln zu schaffen und/oder aber unterschiedliche Potentiale für diese einzelnen Potentialinseln zur Verfügung zu haben, muß ein neues Potential eingespeist werden. Dazu muß die Kontaktierung der aus aneinandergereihten Potentialkontakten KEP gebildeten Potentialkontaktkette gezielt an einer definierten Stelle unterbrochen werden. Bis zur Unterbrechungsstelle liegt dann das bisherige Potential an, nach der Unterbrechungsstelle geht ein neu einzuspeisendes Potential weiter.

Die Unterbrechung der Potentialkontaktkette und die Einspeisung eines neuen Potentials wird mit einem speziellen Potentialeinspeisestecker PS realisiert, dessen exemplarische Ausgestaltung gemäß dem Ausführungsbeispiel in FIG 7 dargestellt ist. Mit dem Potentialeinspeisestecker PS ist es aufgrund dessen konstruktiver Ausgestaltung möglich, die Potentialkontaktkette zu unterbrechen, ein neues Potential einzuspeisen und die Unterbrechung der Potentialkontaktkette auch bei ungewolltem Entfernen des Steckers aufrechtzuerhalten. Dabei wird zur Potentialeinspeisung innerhalb der Potentialkontaktkette, d. h. im Verband der aneinandergereihten Module M, M', kein zusätzlicher Steckplatz benötigt.

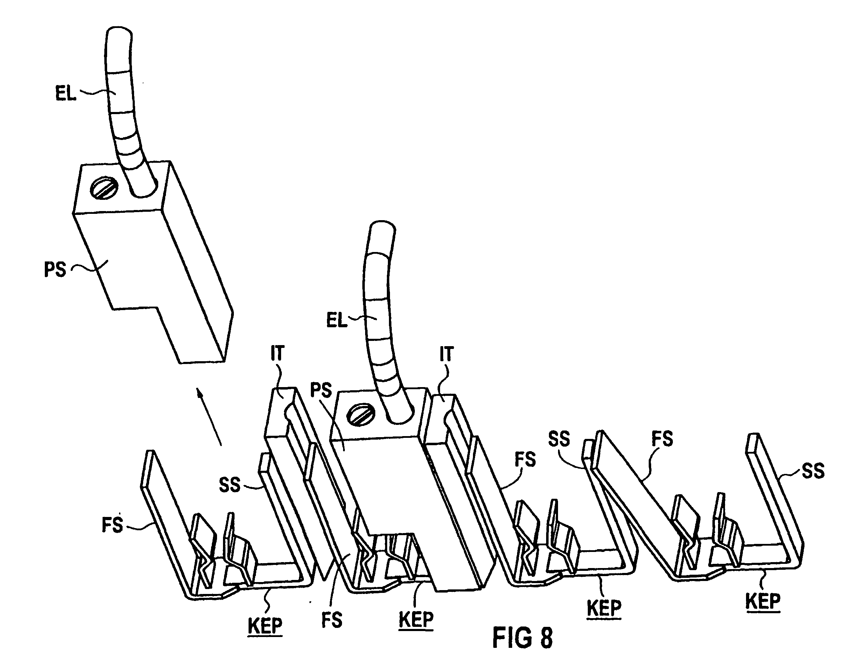

Der Potentialeinspeisestecker PS wird gemäß FIG 8 auf den starren Schenkel SS des Potentialkontaktes KEP aufgesteckt, wobei er die Kontaktstelle zwischen starrem Schenkel SS und anliegendem federndem Schenkel FS des benachbarten Potentialkontaktes KEP unterbricht und damit zur Seite des bisherigen Potentials isolierend wirkt.

Während der Potentialeinspeisestecker PS zur Seite des bisherigen Potentials isolierend wirkt, wirkt er zur Seite des neu aufzubauenden Potentials elektrisch leitend. Der leitfähige Teil ist im Ausführungsbeispiel als Buchse BU ausgeführt. An der gewünschten Stelle im Verband der Potentialkontakte KEP wird der Potentialeinspeisestecker PS mit dem Buchsenteil BU auf den starren Schenkel SS des Potentialkontaktes KEP geschoben. Dabei gelangt der isolierende Bereich des Potentialeinspeisesteckers PS zwischen das aus starrem Schenkel SS eines Potentialkontaktes KEP und federndem Schenkel FS eines benachbarten Potentialkontaktes KEP gebildete Kontaktpaar und drückt den federnden Schenkel FS des benachbarten Potentialkontaktes KEP zur Seite. Die elektrische Verbindung wird damit an dieser Stelle unterbrochen.

Der Potentialeinspeisestecker PS verrastet im Sockelteil ST des Moduls M, M' mittels in den Abbildungen nicht dargestellter Rastelemente. Als Rastelement kann z. B. eine am Potentialeinspeisestecker PS angeordnete Rastnase bzw. Formschlußaufnahme und im Sockelteil ST des Moduls M, M' ein dazu korrespondierendes Rastprofil bzw. Formschlußelement zum Einsatz kommen. Andere lösbare mechanische Fixierungen für den Potentialeinspeisestecker PS sind denkbar. Zum Beispiel kann die Verrastung auch zwischen Potentialeinspeisestecker PS und starrem Schenkel SS erfolgen.

Über den elektrisch leitenden Teil des auf den starren Schenkel SS des Kontaktelementes KEP aufgesteckten Potentialeinspeisesteckers PS, im Ausführungsbeispiel die Buchse BU, kann jetzt über die an den Potentialeinspeisestecker PS angeschlossene elektrische Leitung EL ein neues Potential eingespeist werden und von dieser Stelle aus über die Potentialkontaktkette weitergeleitet werden. Die Potentialweiterleitung erfolgt bis zum Ende der Potentialkontaktkette oder bis zur nächsten Unterbrechungs- bzw. Einspeisungsstelle.

Im Ausführungsbeispiel ist mit dem Potentialeinspeisestecker PS auf dessen isolierender Seite ein Isolierteil IT mechanisch lösbar verbunden. Während des Steckens des Potentialeinspeisesteckers PS auf einen Potentialkontakt KEP wird dieses Isolierteil IT gleichfalls zwischen den beiden zu trennenden Potentialkontaktschenkeln SS, FS plaziert und verrastet entsprechend der obigen Beschreibung mit dem Sockelteil ST desjenigen Moduls M, M', in dem sich der Potentialkontakt KEP, auf dessen starren Schenkel SS der Potentialeinspeisestecker PS gesteckt wurde, befindet.

Wird der Potentialeinspeisestecker PS entfernt, löst sich das Isolierteil IT vom Potentialeinspeisestecker PS und verbleibt weiterhin, unabhängig vom Potentialeinspeisestecker PS, im Sockelteil ST des Moduls M, M', also zwischen den beiden zu trennenden Schenkeln SS, FS der Potentialkontakte KEP. Somit wird ein unkontrolliertes Zusammenschließen (Kurzschluß) unterschiedlicher Potentiale wirksam verhindert.

Dieser Sachverhalt ist anhand von FIG 8 besonders deutlich ersichtlich. FIG 8 zeigt innerhalb der aus benachbarten Potentialkontakten KEP gebildeten Potentialkontaktkette einen aufgesteckten Potentialeinspeisestecker PS mit Isolierteil IT. Das Isolierteil IT des anderen Potentialeinspeisesteckers PS dieser Abbildung, der aus der Potentialkontaktkette gelöst wurde, verbleibt dagegen weiterhin zwischen den benachbarten Potentialkontakten KEP und verhindert deren elektrisch leitende Kontaktierung.

Dies wird erreicht, indem die Verrastung des Isolierteils IT mit dem Sockelteil ST des Moduls wesentlich schwerer lösbar ist, als die Verbindung zwischen Isolierteil IT und Potentialeinspeisestecker PS. Das Stecken des Potentialeinspeisesteckers PS bewirkt eine zwingende Übergabe des Isolierteils IT vom Potentialeinspeisestecker PS an das Sockelteil ST des Moduls M, M'.

Soll die Verbindung der vorher getrennten Potentialkontaktkette wiederhergestellt werden, d. h. ist die Entfernung des Potentialeinspeisesteckers PS bewußt gewünscht, muß das Isolierteil IT mittels eines Werkzeugs (z. B. eines Schraubendrehers) oder - je nach konstruktiver Ausführung - auch von Hand bewußt entfernt werden.

Der Potentialeinspeisestecker PS weist darüber hinaus an seinen Außenflächen in den Figuren nicht dargestellte Rastelemente oder Formschlußelemente bzw. Formschlußaufnahmen auf, mit denen mehrere Potentialeinspeisestecker PS lösbar miteinander in Verbindung gebracht werden können. Mit derart ausgestalteten Potentialeinspeisesteckern PS ist es vorteilhafterweise möglich, eine Vielzahl von Potentialeinspeisesteckern PS zu einer gemeinsam handhabbaren Einheit zusammenzufassen und dann die so gebildete Gruppe von Potentialeinspeisesteckern PS gemeinsam auf die entsprechenden, im Sockelteil ST des Moduls M, M' angeordneten Potentialkontakte KEP aufzustecken. Dies führt sowohl zu einer Arbeitserleichterung als auch zu einer Verbesserung der Übersichtlichkeit bei der Führung der elektrischen Leitungen EL, da zusammengehörige elektrische Leitungen über die Gruppe von Potentialeinspeisesteckern PS zusammengefaßt sind und gemeinsam handhabbar sind.

Der Potentialeinspeisestecker PS wird auf den Potentialkontakt KEP desjenigen Moduls M, M' gesteckt, von welchem aus die Einspeisung eines neuen Potentials beginnen soll. Damit ist kein zusätzlicher Modulsteckplatz im Verband der kaskadierten Module M, M' notwendig.

Der Potentialeinspeisestecker PS wird unterhalb des Elektronikmoduls EM auf das Sockelteil ST gesteckt und verrastet lösbar mit dem Sockelteil ST. Mittels des Potentialeinspeisesteckers PS werden die erforderlichen Versorgungspotentiale, z. B. 24 V, Masse, PE an das Modul M, M' herangeführt und über Kontaktelemente KEP, SK des Sockelteils ST an weitere Kontaktelemente ZDS, EDS der Elektronikmodulleiterplatte ELP und damit schließlich an die Anschlußvorrichtung AV herangeführt, so daß die Versorgungspotentiale zur Spannungsversorgung der Sensoren bzw. Aktoren, die über die Eingangs- bzw. Ausgangskanäle an die Anschlußvorrichtung AV anschließbar sind, zur Verfügung stehen.

Abweichend vom Ausführungsbeispiel gemäß den zuvor beschriebenen Figuren kann die Potentialkontaktkette auch derart ausgebildet sein, daß der Potentialkontakt KEP im wesentlichen Z-förmig mit zwei im wesentlichen parallelen Schenkeln und einer diagonalen Basis ausgebildet ist, wobei einer der Schenkel als federnder Schenkel FS und der andere Schenkel als starrer Schenkel SS ausgebildet ist.

Eine weitere Alternative besteht darin, daß jeweils ein Potentialkontakt KEP mit zwei starren Schenkeln SS einem Potentialkontakt KEP mit zwei federnden Schenkeln FS benachbart angeordnet ist. Auch in diesem Fall trifft an der Kontaktstelle zwischen zwei Potentialkontakten KEP jeweils ein federnder Schenkel FS auf einen starren Schenkel SS, so daß auch bei abweichend ausgestalteten Potentialkontakten KEP eine zuvor beschriebene Kontaktierung ermöglicht ist.

An jedem einzelnen Potentialkontakt KEP befindet sich, mit diesem elektrisch leitend verbunden, ein Steckkontakt SK, der z.B. als direkter oder indirekter Steckkontakt SK ausgebildet sein kann, mit dem eine lösbare elektrisch leitende Verbindung zu entsprechenden direkten oder indirekten Steckverbindern ZDS auf der Elektronikmodulleiterplatte ELP im Elektronikmodul EM herstellbar ist. Die auf der Elektronikmodulleiterplatte ELP aufgebrachten Leiterbahnen dienen damit als elektrisch leitende Verbindung zwischen Sockelteil ST und Anschlußvorrichtung AV. Die Potentialweiterleitung erfolgt dabei über die Elektronikmodulleiterplatte ELP in Form von Leiterzügen sowie direkter oder indirekter Steckverbinder EDS, ZDS bis zu mindestens einer Anschlußvorrichtung AV, die im Frontbereich des Elektronikmoduls EM angeordnet und mit diesem lösbar verbindbar ist.

Gleichzeitig wird von diesen Leiterzügen die Strom- und Spannungsversorgung für die auf der Elektronikmodulleiterplatte ELP angeordnete, in FIG 1 bzw. FIG 2 jedoch nicht dargestellte Elektronik abgegriffen. Die Kontakte EAK auf der Elektronikmodulleiterplatte ELP stellen die Eingangskontakte EAK oder Ausgangskontakte EAK für die einzelnen Kanäle dar, wobei jedem Kanal ein Kontakt zugeordnet ist.

Die Anschlußvorrichtung AV weist Mittel zum Anschluß der nach außen führenden bzw. der von außen eingehenden Potentiale der Ausgangskanäle bzw. Eingangskanäle sowie der Versorgungspotentiale, z. B. 24 V, Masse, PE auf und wird frontseitig auf das Elektronikmodul EM aufgesteckt, wobei beide Teile lösbar miteinander verrasten. Zu diesem Zweck weist das Elektronikmodul EM ein Verriegelungselement VE auf. Die Anschlußvorrichtung AV bildet mit drei weiteren gleichartigen Anschlußvorrichtungen AV einen Anschlußvorrichtungsblock AVB, wobei die einzelnen Anschlußvorrichtungen AV miteinander z. B. über entsprechende Rastelemente bzw. Formschlußelemente und Formschlußaufnahmen lösbar verrastbar bzw. verbindbar sind. Auf der Anschlußvorrichtung AV sind die jeweiligen Beschriftungen aufgebracht.

Die Anschlußvorrichtung AV ist frontseitig auf das Elektronikmodul EM, d. h. auf die direkten oder indirekten Steckverbinder EAK, EDS der im Elektronikmodul EM angeordneten Elektronikmodulleiterplatte ELP aufsteckbar und mit Hilfe des Verriegelungselementes VE mechanisch verriegelbar. Damit ist über die Elektronikmodulleiterplatte ELP die elektrisch leitende Verbindung zwischen den in der Anschlußvorrichtung AV angeordneten Kontaktmitteln und den Potentialkontakten KEP im Sockelteil ST herstellbar. Mit diesen in der Anschlußvorrichtung AV angeordneten Kontaktmitteln sind die Anschlußleitungen der Eingangs- bzw. Ausgangskanäle kontaktierbar.

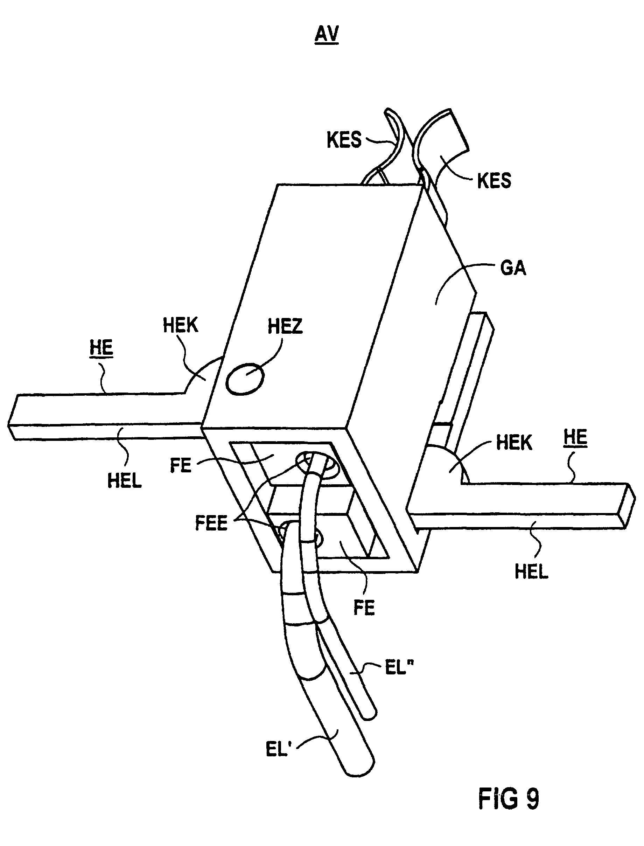

FIG 9 zeigt die Ausführung der elektrischen Anschlußvorrichtung AV gemäß dem Ausführungsbeispiel. Die Anschlußvorrichtung AV weist ein Gehäuse GA auf, in dem die beiden Kontaktelemente KES plaziert sind (Ausführungsbeispiele mit anderen Anzahlen von Kontaktelementen KES und zugehörigen entsprechenden weiteren mechanischen und elektrischen Elementen gemäß der nachfolgenden Beschreibung sind gleichfalls denkbar.). In das Gehäuse GA sind ferner die beiden Führungselemente FE eingeführt. Die Führungselemente FE weisen eine Einführbohrung mit einer Einführöffnung FEE auf. In die Einführbohrung der Führungselemente FE sind elektrische Leitungen EL', EL'' eingeführt, wobei in das erste Führungselement FE eine elektrische Leitung mit großem Querschnitt EL' und in das zweite Führungselement FE eine elektrische Leitung mit geringem Querschnitt EL'' eingeführt ist.

Im Gehäuse GA der Anschlußvorrichtung AV ist ein drehbares Hebelelement HE mit einem im Ausführungsbeispiel als Exzenter HEK ausgebildeten kurzen Hebelarm HEK und einem langen Hebelarm HEL angeordnet. Mit dem kurzen Hebelarm HEK greift das Hebelelement HE in das Gehäuse GA der elektrischen Anschlußvorrichtung AV ein, wobei das Hebelelement HE am langen Hebelarm HEL von außerhalb des Gehäuses GA betätigbar ist. Im Ausführungsbeispiel weist das Hebelelement HE einen Zapfen HEZ auf, der in eine entsprechende Bohrung des Gehäuses GA eingreift und als Drehachse des Hebelelementes HE wirkt.

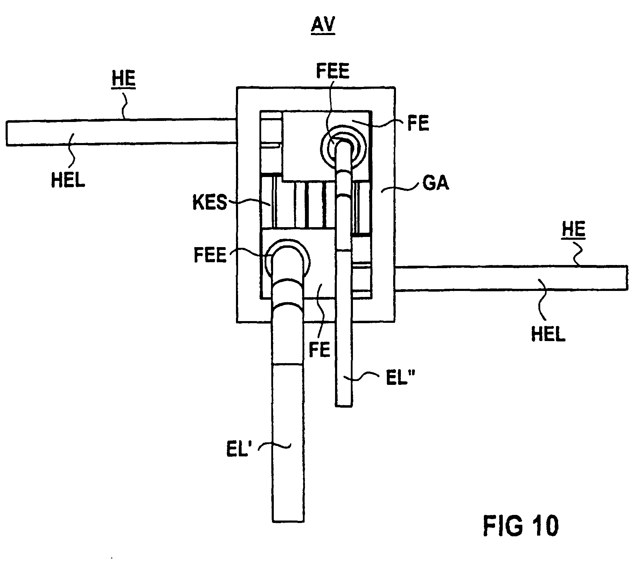

FIG 10 zeigt die elektrische Anschlußvorrichtung von der Rückseite, also von der Seite, von der die elektrischen Leitungen EL', EL" in die Einführbohrung der Führungselemente FE eingeführt sind. Anhand von FIG 10 wird deutlich, daß jedes der beiden Hebelelemente HE auf jeweils eines der Führungselernente FE einwirkt. Die FIG 9 und 10 zeigen die Hebelelemente HE in einer Position, in der die Führungselemente FE in das Gehäuse GA der elektrischen Anschlußvorrichtung AV einführbar bzw. aus diesem entnehmbar sind. Mit dem Betätigen der Hebelelemente HE an ihrem langen Hebelarm HEL werden die Führungselemente FE in Richtung auf die dem Hebelelement HE gegenüberliegende Außenwand des Gehäuses GA und dabei gegen das Kontaktelement KES, das an dieser Stelle angeordnet ist, gepreßt.

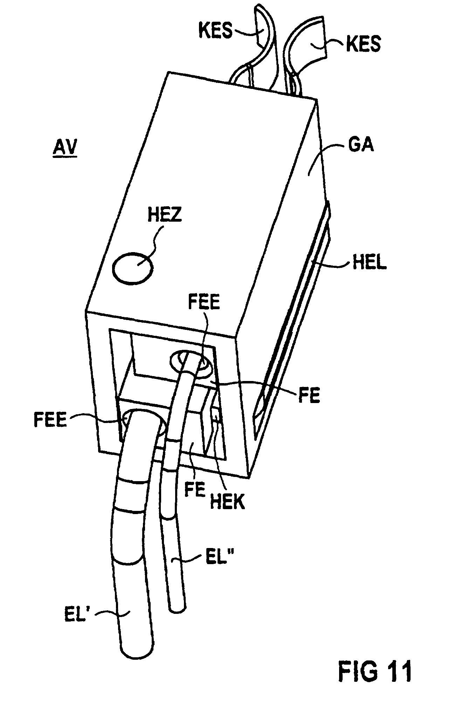

FIG 11 zeigt die elektrische Anschlußvorrichtung AV mit betätigten Hebelelementen HE, d.h. die langen Hebelarme HEL der Hebelelemente HE sind bis in dafür vorgesehene Ausnehmungen des Gehäuses GA bewegt, wobei der kurze Hebelarm HEK in in FIG 11 nicht dargestellter Weise das Führungselement FE gegen das Kontaktelement KES preßt, womit ein elektrisch leitender Kontakt zwischen den elektrischen Leitungen EL', EL" und dem jeweiligen Kontaktelement KES bewirkt wird.

Mit betätigten Hebelelementen HE ergibt sich für die elektrische Anschlußvorrichtung AV eine quaderförmige, konvexe Außenkontur, die insbesondere ein Anreihen gleichartiger Anschlußvorrichtungen AV erlaubt. Dazu weist die elektrische Anschlußvorrichtung AV auf mindestens einer der Seitenflächen des Gehäuses GA eine in FIG 11 nicht dargestellte Formschlüßaufnahme und mindestens auf einer dieser ersten Seitenfläche des Gehäuses GA gegenüberliegenden zweiten Seitenfläche ein entsprechendes Formschlußelement auf. Damit ist die elektrische Anschlußvorrichtung AV kaskasdierbar, so daß funktional oder elektrisch zusammengehörige elektrische Leitungen EL', EL'' gemeinsam, also in einem Block gleichartiger elektrischer Anschlußvorrichtungen AV handhabbar sind.

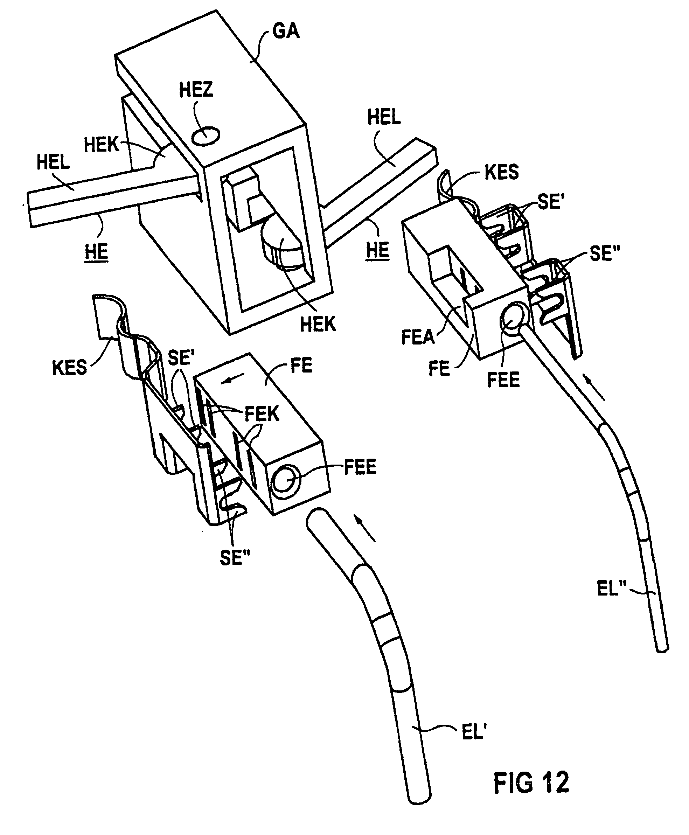

FIG 12 zeigt die elektrische Anschlußvorrichtung AV in einer Teil-Explosionsdarstellung, die das Erkennen des Zusammenwirkens der mechanischen Komponenten der Anschlußvorrichtung AV im Innern des Gehäuses GA erleichtert.

Das Gehäuse GA weist eine schlitzförmige Ausnehmung auf, in die das Hebelelement HE einführbar ist. Das Hebelelement HE ist in dieser Ausnehmung und damit zumindest teilweise innerhalb des Gehäuses GA angeordnet, wobei zur leichten Plazierung des Hebelelementes HE entweder das Gehäuse GA mehrteilig ausgebildet sein kann, oder aber der als Drehachse des Hebelelementes HE wirkende Zapfen HEZ nachträglich durch die entsprechende Ausnehmung im Gehäuse GA in das Hebelelement HE einbringbar ist.

Im Innern der Gehäuses GA erkennt man die im Bereich der schlitzförmigen Ausnehmung speziell gestaltete Innenkontur des Gehäuses GA, die für den langen Hebelarm HEL als Anschlag wirkt. Im eingeschwenkten Zustand schließt damit das Hebelelement HE bündig mit der Außenkontur des Gehäuses GA ab.

Wie besonders deutlich in FIG 12 zu erkennen ist, ist der kurze Hebelarm HEK des Hebelelementes HE als Exzenter HEK ausgebildet, wobei der wirksame Radius des Exzenters HEK auf der in direkter Verlängerung des langen Hebelarms HEL gegenüberliegenden Seite des Zapfens HEZ gering ist und entlang der kreisförmigen Kontur auf der in das Gehäuseinnere gewandten Seite in Richtung auf den langen Hebelarm HEL stetig zunimmt.

Der Exzenter HEK des Hebelelementes HE greift in eine Ausnehmung FEA des Führungselementes FE ein. Das Führungselement FE ist in das Gehäuse GA nur einführbar, wenn der lange Hebelarm HEL des Hebelelementes HE aus dem Gehäuse GA herausgeschwenkt ist, wie dies in FIG 9 dargestellt ist. Denn dann ist der ins Gehäuseinnere gerichtete wirksame Radius des Exzenters HEK gering. Das Führungselement FE kann also in das Gehäuse GA eingeführt werden, wie dies in FIG 10 dargestellt ist. Beim Betätigen des Hebelelementes HE greift der Exzenter HEK in die Ausnehmung FEA des Führungselementes FE ein. Das Führungselement FE kann also in einer der Einführrichtung entgegengerichten translatorischen Bewegung aus dem Gehäuse GA der elektrischen Anschlußvorrichtung nicht mehr herausbewegt werden.

Wird der lange Hebelarm HEL des Hebelelementes HE weiter in Richtung auf das Gehäuse GA, also in Richtung auf die schlitzförmige Ausnehmung des Gehäuses GA, geschwenkt, so preßt der stetig größer werdende wirksame Radius des Exzenters HEK das Führungselement FE gegen das gleichfalls im Gehäuse GA angeordnete Kontaktelement KES, wobei die im Ausführungsbeispiel am Kontaktelement KES angeordneten Schneidelemente SE', SE" in Kontaktierungsausnehmungen FEK des Führungselementes FE eingreifen.

Im Ausführungsbeispiel weist das Kontaktelement KES zwei Schneidelemente SE', SE" auf, die eine von einem isolierenden Mantel umgebene elektrische Leitung EL', EL" in an sich bekannter Weise kontaktieren. Ein Abisolieren der elektrischen Leitungen EL', EL'' ist also in diesem Falle nicht erforderlich.

Selbstverständlich ist es auch möglich, das Führungselement FE durch entsprechende Kontaktierungsausnehmungen FEK so zu gestalten, daß eine im Bereich des in die Einführbohrung des Führungselementes FE eingeführte und abisolierte elektrische Leitung EL', EL'' mit einem korrespondierend ausgestalteten Kontaktelement KES kontaktiert wird. Die Schneidelemente SE', SE'' des Kontaktelementes KES stellen somit ausdrücklich nur eine exemplarische Ausgestaltung dar, wobei mit Hilfe der Schneidelemente SE', SE" eine sichere und besonders schnelle Kontaktierung der elektrischen Leitung EL', EL" gewährleistet ist, da das zeitaufwendige Abisolieren der elektrischen Leitungen EL', EL'', üblicherweise mit einem entsprechenden Werkzeug ausgeführt, entfällt.

Die elektrische Anschlußvorrichtung AV gemäß den Figuren 9 bis 12 weist zwei Kontaktelemente KES auf, die an den gegenüberliegenden Innenseiten des Gehäuses GA angeordnet sind. Mittels ebenfalls an gegenüberliegenden Innenseiten des Gehäuses angeordneter Hebelelemente HE ist jeweils eines der Führungselemente FE gegen jeweils eines der Kontaktelemente KES preßbar.

Im Ausführungsbeispiel ist das Kontaktelement KES im vorderen Bereich als Federelement ausgebildet und kontaktiert z.B. eine Leiterbahn einer elektrischen Leiterplatte, die im Bereich, in dem die Anschlußvorrichtung AV an die Leiterplatte herangeführt wird, als direkter Steckverbinder ausgebildet ist. Auf diese Weise kann mit der elektrischen Anschlußvorrichtung AV eine Leiterbahn auf der einen Seite der Leiterplatte mit der elektrischen Leitung EL' und eine Leiterbahn auf der anderen Seite der Leiterplatte mit der elektrischen Leitung EL'' elektrisch leitend verbunden werden. Die vorderen Teile des Kontaktelementes KES können jedoch genauso z.B. als Stift oder als Buchse ausgeformt sein.

Das Führungselement FE begrenzt durch eine entsprechende geometrische Ausgestaltung der Einführbohrung die Einstecktiefe der elektrischen Leitung EL', EL''. Dazu ist der Querschnitt der Einführbohrung im hinteren Bereich der Einführbohrung zumindest stückweise geringer als im Bereich der Einführöffnung FEE. Eine elektrische Leitung mit geringem Querschnitt EL" ist daher tiefer in die Einführbohrung des Führungselementes FE einführbar, als eine elektrische Leitung mit großem Querschnitt EL'. In den hinteren Bereich der Einführbohrung, in den nur noch die elektrische Leitung EL" mit geringem Querschnitt einführbar ist, greifen durch die entsprechenden Kontaktierungsausnehmungen FEK nur noch die Schneidelemente SE'' ein. Die Schneidelemente SE" unterscheiden sich von den Schneidelementen SE' dadurch, daß sie eine elektrische Leitung mit geringem Querschnitt EL'' kontaktieren, während die Schneidelemente SE' eine elektrische Leitung mit größerem Querschnitt EL' kontaktieren.

Bei einer bis in den hinteren Bereich der Einführbohrung eingeführten elektrischen Leitung EL'' kontaktieren somit beim Anpressen des Führungselementes FE gegen das Kontaktelement KES die Schneidelemente SE'' den elektrischen Leiter der elektrischen Leitung EL'', während die auf eine elektrische Leitung mit größerem Querschnitt EL' abgestimmten Schneidelemente SE' die elektrische Leitung mit geringem Querschnitt EL" im wesentlichen nicht kontaktieren.

Demgegenüber wird eine nur bis zum Beginn des hinteren Bereichs der Einführbohrung des Führungselementes FE einführbare elektrische Leitung EL' durch die für eine elektrische Leitung mit größeren Querschnitt EL' konfektionierten Schneidelemente SE' sicher kontaktiert. Die Schneidelemente SE' und SE'' sind dabei untereinander selbstverständlich elektrisch leitend verbunden, da sie jeweils an dem elektrisch leitenden Kontaktelement KES angeordnet sind.

Die Anschlußvorrichtung AV bzw. der jeweilige Anschlußvorrichtungsblock AVB ist komplett verdrahtet vom Elektronikmodul EM lösbar, so daß sich eine sogenannte stehende Verdrahtung ergibt. Es können somit sowohl die Anschlußvorrichtung AV separat als auch die Anschlußvorrichtung AV mitsamt dem Elektronikmodul EM abgezogen werden; weder die Potentialweiterleitung noch die Busweiterleitung von einem Sockelteil ST zu einem benachbarten weiteren Sockelteil ST wird durch dieses Abziehen beeinflußt. An der Anschlußvorrichtung AV ist auch eine Steckerbeschriftung anbringbar.

Natürlich ist es auch möglich, ein spezielles Einspeisemodul vorzusehen, das erforderlichenfalls auch eine Sicherung aufweist, wobei der wesentliche konstruktive Aufbau eines solchen Einspeisemoduls derjenigen der zuvor beschriebenen Module M, M' entspricht.

Das Elektronikmodul EM bildet mit seinem oberen Bereich, in dem z. B. Anzeige- und/oder Bedienelemente BE angeordnet sind, und der Anschlußvorrichtung AV gemeinsam die Modulscheibenfront. Beispiele für Anzeigeelemente BE sind z. B. Zustandsanzeigen oder LEDs; Beispiele für Bedienelemente BE sind z. B. Adresseneinstellschalter. Anschlußvorrichtung AV und Elektronikmodul EM sind also beide ohne weiteres von vorn in ihrem Frontbereich zugänglich und damit bedienbar und anschließbar, wobei auch die Beschriftung ablesbar ist.

Im Elektronikmodul EM werden alle elektronischen Funktionen realisiert. Dies sind z. B. Eingabe- bzw. Ausgabeschaltungen für zwei Kanäle. In Fortführung des erfindungsgemäßen Aufbauprinzips sind aber auch weitere Funktionsmodule realisierbar, die einen größeren Platzbedarf als z. B. zweikanalige Eingabe- bzw. Ausgabeschaltungen haben. Diese Funktionsmodule können bedingt durch ihren internen Aufbau die Breite von zwei oder mehreren Elektronikmodulen EM haben. Alle Elektronikmodule EM, Sockelteile ST, Anschlußvorrichtung AV und Potentialeinspeisestecker PS sind so ausgelegt, daß sie in ein Systemraster passen.

Die Auslegung der Sockelteile ST ermöglicht es, diese breiten Funktionsmodule, wenn erforderlich, auf zwei oder mehrere Sockelteile ST nach dem zuvor am Beispiel der Elektronikmodule EM beschriebenen Prinzip zu stecken.

Das Aufbau- und Konstruktionsprinzip läßt es darüber hinaus zu, optional auch breitere Sockelteile für die breiten Funktionsmodule analog zu dem zuvor beschriebenen Aufbau zu schaffen.

Artgleich ist der Aufbau und die Konstruktion von Kopfmodulen realisierbar. Die Flexibilität und Vielseitigkeit des erfindungsgemäßen Systems wird dadurch nochmals erweitert und deutlich unterstrichen.

In einer Ausgestaltung der Erfindung ist für das Kontaktsystem eine Potentialeinspeisung in der Form vorgesehen, daß ein auf den starren Schenkel des Potentialkontaktes lösbar aufsteckbarer Potentialeinspeisestecker im aufgesteckten Zustand die Kontaktierung zwischen federndem Schenkel des im ersten Modul angeordneten Potentialkontaktes und starrem Schenkel des im zweiten Modul angeordneten Potentialkontaktes unterbricht. Damit wird an der Stelle, an der der Potentialeinspeisestecker auf den Potentialkontakt aufgesteckt wird, die Potentialweiterleitung zwischen benachbarten Potentialkontakten unterbrochen und statt dessen ab dem Potentialkontakt, auf das der Potentialeinspeisestecker aufgesteckt wurde, an sämtliche weiteren Potentialkontakte, die mit diesem Potentialkontakt kontaktiert bzw. mit diesem elektrisch leitend verbunden sind, das mit dem Potentialeinspeisestecker eingespeiste Potential weitergeleitet.

Wenn an die Module des elektrischen Gerätes z. B. Aktoren oder Sensoren zur Steuerung und/oder Überwachung eines technischen Prozesses angeschlossen sind, wobei die Versorgungsspannung dieser Aktoren bzw. Sensoren von den in den Modulen angeordneten Kontaktelementen abgegriffen wird und wobei weiterhin eine erste Gruppe von Aktoren bzw. Sensoren eine erste Versorgungsspannung benötigen und wobei eine zweite Grupppe von Aktoren bzw. Sensoren eine zweite, von der ersten Versorgungsspannung verschiedene Versorgungsspannung benötigen, ist es von Vorteil, wenn in jedem Modul eine der Anzahl der unterschiedlichen Versorgungsspannungen entsprechende Anzahl von Kontaktelementen angeordnet ist.

Die Flexibilität und Vielseitigkeit des erfindungsgemäßen Automatisierungsgerätes bei gleichzeitig verbesserter Konfigurierbarkeit wird gemäß einer Ausgestaltung der Erfindung nochmals erhöht, wenn das elektrische Gerät zumindest ein Senderelement und/oder ein Empfängerelement auf einer in einem Elektronikmodul plazierbaren Elektronikmolulleiterplatte und einer davon potential getrennten Signalverarbeitungseinrichtung auf einer von der Elektronikmodulleiterplatte getrennten Busleiterplatte aufweist, wobei ein dem Senderelement zugeordnetes Empfängerelement und/oder ein dem Empfängerelement zugeordnetes Senderelement auf der Busleiterplatte plazierbar ist.

Der Vorteil dieser Ausgestaltung des elektrischen Gerätes besteht darin, daß die bei bekannten Lösungen für elektrische Geräte der eingangs genannten Art erforderlichen zwei Schnittstellenebenen zwischen Elektronikmodulleiterplatte und Busleiterplatte, wobei eine Schnittstellenebene durch Optokoppler und eine weitere Schnittstellenebene durch einen Steckverbinder, der die Elektronikmodulleiterplatte und die Busleiterplatte elektrisch leitend miteinander verbindet, gebildet wird, zu einer einzigen Schnittstellenebene zusammengefaßt sind.

Auf der Elektronikmodulleiterplatte ist z.B. eine Digitaleingabeschaltung zur Detektion binäre Signale, die von Sensoren eines externen technischen Prozesses geliefert werden, oder eine Digitalausgabeschaltung, die binäre Signale an Aktoren und/oder Stellglieder eines externen technischen Prozesses ausgibt, angeordnet. Mit einem gemäß der Erfindung ausgestalteten elektrischen Gerät ist es dann möglich, den auf der von der Busleiterplatte getrennten Elektronikmodulleiterplatte angeordneten Digitalausgabeschaltkreis bzw. Digitaleingabeschaltkreis jederzeit von der Busleiterplatte zu lösen, um etwa eine defekte Elektronikmodulleiterplatte schnellstmöglichst auszutauschen.

Wenn auf der Busleiterplatte sowohl ein Senderelement als auch ein Empfängerelement plazierbar ist, ist es möglich, dieser Busleiterplatte eine Elektronikmodulleiterplatte zuzuordnen, auf der entweder ein Empfängerelement mit einem Digitaleingabeschaltkreis angeordnet ist. Die Flexibilität des erfindungsgemäßen elektrischen Gerätes ist damit entscheidend erhöht, da der Anwender jeder Busleiterplatte auf einer Elektronikmodulleiterplatte sowohl eine Digitaleingabe als auch eine Digitalausgabe zuordnen kann.

Die Flexibilität und Vielseitigkeit des erfindungsgemäßen elektrischen Gerätes wir nochmals erhöht, wenn das elektrische Gerät eine in einem Gehäuse plazierte elektrische Anschlußvorrichtung aufweist, in der mindestens ein Kontaktelement plazierbar ist und in das zumindest ein Führungselement einführbar ist, wobei das Führungselement eine Einführbohrung mit einer Einführöffnung aufweist, in die eine elektrische Leitung einführbar ist und wobei das Führungselement mindestens eine Kontaktierungsausnehmung aufweist, wobei im Gehäuse ein drehbares Hebelelement angeordnet ist, wobei dieses mit seinem kurzen Hebelarm in das Gehäuse eingreift und an seinem langen Hebelarm von außerhalb des Gehäuses betätigbar ist und wobei mit Betätigen des langen Hebelarmes der kurze Hebelarm das Führungselement gegen das Kontaktelement preßt, wobei das Kontaktelement in die Kontaktierungsausnehmung eingreift.

Mit einer derart ausgestalteten Anschlußvorrichtung ist es möglich, die elektrische Leitung mittels des Führungselementes, in dessen Einführbohrung die elektrische Leitung einführbar ist, in bezug auf das Kontaktelement so zu positionieren, daß eine sichere und definierte Kontaktierung bewirkbar ist. Das im Gehäuse gleichfalls angeordnete drehbare Hebelelement, das mit seinem kurzen Hebelarm in das Gehäuse eingreift und das an seinem langen Hebelarm von außerhalb des Gehäuses betätigbar ist, ermöglicht es, daß die sichere und definierte Kontaktierung der elektrischen Leitung mit dem Kontaktelement mit verhältnismäßig geringem Kraftaufwand bewirkbar ist, indem mit Betätigen des langen Hebelarms der kurze Hebelarm das Führungselement gegen das Kontaktelement preßt, wobei das Kontaktelement in die Kontaktierungsausnehmung eingreift und damit eine in die Einführbohrung des Führungselementes eingeführte elektrische Leitung kontaktiert.

Wenn der kurze Hebelarm des Hebelelements als Exzenter ausgebildet ist, steigt beim Betätigen des langen Hebelarms die mit dem kurzen Hebelarm auf das Führungselement ausgeübte Kraft im wesentlichen linear an. Dies ist bedingt durch die Tatsache, daß sich ja nach wirksamen Abschnitt, d.h. je nach am Führungselement anliegenden Sektor des Exzenters, aufgrund des sich ändernden Radiusses des Exzenters und damit aufgrund der wirksamen Länge des kurzen Hebelarms das Längenverhältnis der beiden Hebelarme ändert. Mit einem als Exzenter ausgebildeten kurzen Hebelarm des Hebelelementes ist damit ein besonders kraftsparendes Anpressen des Führungselementes an das Kontaktelement möglich. Außerdem ist durch den Exzenter der lange Hebel an seiner Basis, also in der Nähe des Drehpunktes des Hebelelementes verstärkt, so daß die Gefahr des Abbrechens des langen Hebelarmes reduziert ist.

Wenn das Kontaktelement mindestens ein Schneidelement aufweist und das Schneidelement beim mit dem Betätigen des langen Hebelarmes bewirkten Anpressen des Führungselementes gegen das Kontaktelement in die Kontaktierungsausnehmung eingreift, ist eine sichere und definierte Kontaktierung elektrischer Leitungen, die in die Einführbohrung des Führungselementes eingeführt sind, auch für elektrische Leitungen, deren Isolierung im Anschluß- bzw. Kontaktbereich nicht zuvor entfernt wurde, möglich. In diesem Falle trennt das Schneidelement in an sich bekannter Weise die Isolierung der elektrischen Leitung auf und kontaktiert damit gleichzeitig elektrische leitend die ansonsten von der Isolierung umschlossene Leitung.

Wenn in dem Gehäuse der elektrischen Anschlußvorrichtung des erfindungsgemäßen elektrischen Gerätes zwei Kontaktelemente plazierbar sind und in das Gehäuse zwei Führungselemente einführbar sind, ist es möglich, zwei elektrische Leitungen, die jeweils in eines der beiden Führungselemente einführbar sind, mittels der elektrischen Anschlußvorrichtung z.B. mit einem elektrischen Gerät zu kontaktieren. Wenn die beiden Kontaktelemente innerhalb der elektrischen Anschlußvorrichtung z.B. elektrisch leitend verbunden sind, ist es damit in einfacher Weise möglich, ein z.B. einem ersten elektrischen Gerät zugeführtes elektrisches Potential in gleicher Weise auch einem weiteren elektrischen Gerät zuzuführen, indem mit der mit dem ersten Kontaktelement kontaktierten elektrischen Leitung das Potential an das erste elektrische Gerät herangeführt wird und indem mit der mit dem zweiten Kontaktelement kontaktierten elektrischen Leitung dasselbe Potential auch an ein anderes elektrisches Gerät herangeführt wird.

Wenn zwei Kontaktelemente der elektrischen Anschlußvorrichtung des erfindungsgemäßen elektrischen Gerätes an gegenüberliegenden Innenseiten des Gehäuses angeordnet sind, ist es z.B. möglich, Leiterbahnen einer Leiterplatte, die in dem Bereich, in dem die elektrische Anschlußvorrichtung an die Leiterplatte herangeführt ist, als direkter Steckverbinder ausgebildet ist, auf jeder Seite der Leiterplatte zu kontaktieren. Die zwei Kontaktelemente sind dabei je nach Anwendungsfall entweder voneinander elektrisch isoliert oder aber elektrisch leitende miteinander kontaktiert.

Wenn die elektrische Anschlußvorrichtung des erfindungsgemäßen elektrischen Gerätes an zumindest einer der Seitenflächen des Gehäuses ein Formschlußelement bzw. eine Formschlußaufnahme aufweist, ist es möglich, die elektrische Anschlußvorrichtung mit ihrem Gehäuse mechanisch lösbar z.B. mit einem ein entsprechende Formschlußaufnahme bzw. ein entsprechendes Formschlußelement aufweisenden elektrischen Gerät, an das mittels der erfindungsgemäßen Anschlußvorrichtung Potentiale oder Signale herangeführt sind, lösbar zu verbinden.

Die elektrische Anschlußvorrichtung des erfindungsgemäßen elektrischen Gerätes ist darüber hinaus oder alternativ kaskadierbar, wenn zumindest eine der Seitenflächen des Gehäuses ein Formschlußelement aufweist und wenn die der zumindest einen Seitenfläche gegenüberliegende Seitenfläche eine korrespondierende Formschlußaufnahme aufweist. Es ist dann vorteilhafterweise möglich, mehrere der erfindungsgemäßen elektrischen Anschlußvorrichtungen zu einem elektrischen Anschlußvorrichtungsblock zusammenzufügen und damit zusammengehörige elektrische Leitungen mit ihrer jeweiligen Anschlußvorrichtung einfach zu handhaben.

Wenn der Querschnitt der Einführbohrung des Führungselementes der elektrischen Anschlußvorrichtung des erfindungsgemäßen elektrischen Gerätes im hinteren Bereich der Einführbohrung zumindest stückweise geringer ist als im Bereich der Einführöffnung, ist es möglich, in das Führungselement elektrische Leitungen mit unterschiedlichem Querschnitt einzuführen und dabei diese elektrischen Leitungen an einer definierten Position zu kontaktieren. Dies ist insbesondere dann vorteilhaft, wenn das Kontaktelement z.B. ein erstes Schneidelement für einen geringeren Querschnitt aufweist.

Ein Kontaktieren der elektrischen Leitung mit großem Querschnitt mit dem Schneidelement für den geringen Querschnitt würde auch den Leiter der elektrischen Leitung selbst beschädigen, während beim Versuch, einen elektrischen Leiter mit geringem Querschnitt mit einem Schneidelement für einen großen Querschnitt zu kontaktieren, oftmals keine befriedigende elektrische Kontaktierung erreichbar ist.

Wenn der Querschnitt der Einführbohrung des Führungselementes im hinteren Bereich der Einführbohrung zumindest stückweise geringer ist, als im Bereich der Einführöffnung, lassen sich in diesem hinteren Bereich der Einführbohrung nur noch elektrische Leitungen mit einem entsprechend geringen Querschnitt einführen. Elektrische Leitungen, die sich aufgrund ihres Querschnittes in diesen Abschnitt der Einführbohrung nicht mehr einführen lassen, werden von einem Kontaktelement im vorderen Bereich der Einführbohrung kontaktiert; Leitungen, die sich auch in den hinteren Bereich der Einführbohrung einführen lassen, werden zumindest im hinteren Bereich der Einführbohrung vom entsprechenden Kontaktelement kontaktiert.

## Patentansprüche

1. Elektrisches Gerät mit modularer Aufbautechnik, insbesondere modulares Automatisierungsgerät, zur Steuerung und/oder Überwachung eines externen technischen Prozesses,
- dessen Module (M, M') nebeneinander plazierbar sind,
- wobei in einem ersten Modul M und in einem zweiten Modul M', die benachbart angeordnet sind und mittels eines Bussystems kommunikativ verbindbar sind, jeweils ein Buskontaktelement BK und ein Busgegenkontaktelement BGK angeordnet sind, wobei zur kommunikativen Verbindung der benachbarten Module M, M' eine Busleiterplatte BLP vorgesehen ist, mit einem zum Buskontaktelement korrespondierenden Bussteckverbinderkontaktelement BSK und zu einem zum Busgegenkontaktelement BGK korrespondierenden Bussteckverbinder-Gegenkontaktelement BSGK.

2. Elektrisches Gerät nach Anspruch 1, **dadurch gekennzeichnet, daß** die Busleiterplatte BLP die Elektronik des aktiven Rückwandbusses mit geeigneter Ankopplung an die Elektronik eines mit dem Sockelteil ST verbindbaren Elektronikmoduls EM aufweist.

3. Elektrisches Gerät nach Anspruch 1 oder 2, **dadurch gekennzeichnet, daß** die Busleiterplatte elektronische Bauelemente aufweist, die für die Erkennung des jeweiligen Steckplatzes erforderlich sind.

## Claims

1. Electrical device of modular design, in particular a modular automation device for controlling and/or monitoring an external technical process
- whose modules (M, M') are placed next to one another,
- where a first module M and a second module M', which are arranged next to one another and can be connected for communication purposes by means of a bus system, each contains a bus contact element BK and a bus mating contact element BGK, where a bus board BLP is provided for the communication link between the neighbouring modules M, M', with a bus connector contact element BSK corresponding to the bus contact element and a bus connector mating contact element BSGK corresponding to the bus mating contact element BGK.

2. Electrical device according to Claim 1, **characterised in that** the bus board BLP contains the electronics of the active backplane bus with appropriate coupling to the electronics of an electronic module EM that can be connected to the socket unit ST.

3. Electrical device according to Claim 1 or 2, **characterised in that** the bus board contains electronic components necessary for detecting the relevant slot.

## Revendications

1. Appareil électrique de conception modulaire, en particulier appareil modulaire d'automatisation, destiné à commander et/ou à surveiller une opération technique externe,
- dont les modules (M, M') peuvent être placés l'un à côté de l'autre,
- dans lequel un élément de contact de bus BK et un élément de contre-contact de bus BGK sont respectivement disposés dans un premier module M et dans un deuxième module M' qui sont placés à proximité l'un de l'autre et peuvent être mis en communication à l'aide d'un système de bus, dans lequel afin d'assurer la mise en communication des modules M, M' voisins on prévoit une plaquette de bus BLP, comportant un élément de contact pour fiche de raccordement de bus BSK qui correspond à l'élément de contact de bus et un élément de contre-contact pour fiche de raccordement de bus BSGK qui correspond à l'élément de contre-contact de bus BGK.

2. Appareil électrique selon la revendication 1, **caractérisé en ce que** la plaquette de bus BLP présente l'électronique du bus actif de la paroi arrière comportant un couplage adapté à l'électronique d'un module électronique EM qu'on peut relier à la partie de socle ST.

3. Appareil électrique selon la revendication 1 ou 2, **caractérisé en ce que** la plaquette de bus présente des composants électroniques qui sont nécessaires pour reconnaître la fente d'extension concernée.
